Europäisches Patentamt

European Patent Office

Office européen des brevets

(19)

(11) Veröffentlichungsnummer : **0 254 145**
**B1**

(12) **EUROPÄISCHE PATENTSCHRIFT**

(45) Veröffentlichungstag der Patentschrift :
24.01.90

(21) Anmeldenummer : 87109909.9

(22) Anmeldetag : 09.07.87

(51) Int. Cl.$^5$ : **C 23 C 14/50, B 65 G 49/06**

(54) Transporteinrichtung mit Rollensystemen für Vakuum-Beschichtungsanlagen.

(30) Priorität : 16.07.86 DE 3623970

(43) Veröffentlichungstag der Anmeldung :
27.01.88 Patentblatt 88/04

(45) Bekanntmachung des Hinweises auf die Patenterteilung : 24.01.90 Patentblatt 90/04

(84) Benannte Vertragsstaaten :
CH DE FR GB IT LI NL SE

(56) Entgegenhaltungen :
DD—A— 228 305
DE—A— 2 851 255
US—A— 4 042 128
US—A— 4 498 832
US—A— 4 592 308
Patent Abstracts of Japan, unexamined applications,
C field, vol. 7, No. 263, 24 November 1983 The Patent
Office Japanese Government Seite 40 C 196

(73) Patentinhaber : LEYBOLD AKTIENGESELLSCHAFT
Wilhelm-Rohn-Strasse 25
D-6450 Hanau am Main 1 (DE)

(72) Erfinder : Anderle, Friedrich
Reichenberger Strasse 51
D-6450 Hanau am Main (DE)

(74) Vertreter : Zapfe, Hans, Dipl.-Ing.
Am Eichwald 7
D-6056 Heusenstamm - 2 (Rembrücken) (DE)

Jouve, 18, rue St-Denis, 75001 Paris, France

## Beschreibung

Die Erfindung betrifft eine Transporteinrichtung für Vakuum-Beschichtungsanlagen mit mehreren Stationen und mit Rollensystemen für die Führung und den Vorschub von im wesentlichen zweidimensionalen Substrathaltern in senkrechter Stellung entlang eines vorgegebenen Transportweges durch die Stationen, wobei im Bereich der Unterkante der Substrathalter paarweise Führungsrollen angeordnet sind, die den Substrathalter zwischen sich aufnehmen und die um senkrechte Achsen A1, A2 drehbar sind.

Die zum Einsatz kommenden Substrathalter sind entweder Platten mit entsprechend den Substraten geformten Ausschnitten oder Rahmen mit Streben, an denen die Substrate befestigt werden. Im allgemeinen dient ein Substrathalter zur Aufnahme einer Vielzahl von Substraten. Da die Dicke einer solchen Platte oder eines Rahmens sehr klein im Verhältnis zu deren bzw. dessen Hauptebene ist, kann ein solcher Substrathalter vereinfacht als zweidimensional bezeichnet werden.

Durch die US-PS 4 042 128 ist eine Transporteinrichtung der eingangs beschriebenen Gattung bekannt, bei der plattenförmige Substrathalter bei vertikaler Lage ihrer Hauptebene an ihren oberen und unteren Längskanten zwischen Rollen geführt werden, die um senkrechte Achsen drehbar sind. An ihren Unterkanten liegen die Substrathalter zusätzlich auf Stützrollen mit horizontaler Drehachse auf. Die unteren Führungsrollen sind jedoch nicht im Stande, die Substrathalter allein in genau vertikaler Stellung zu halten und zu transportieren, so daß eine stabile Positionierung nur unter Zuhilfenahme der oberen Führungsrollen möglich ist.

Nun werden aber beim Beschichtungsvorgang auch die Substrathalter mit beschichtet, wobei die Schichtdicke im Laufe der Zeit anwächst, bis an einzelnen Stellen eine Ablösung von Schichtpartikeln stattfindet. Diese Ablösung wird durch die Führungsrollen erheblich begünstigt, wobei insbesondere die jeweils oberen Führungsrollen dazu führen, daß die Substrate durch einen Regen von abgeplatzten bzw. abgeschälten Schichtpartikeln geführt werden, so daß sich eine fehlerhafte Beschichtung mit den gefürchteten « pin holes » ergibt.

Der Erfindung liegt daher die Aufgabe zugrunde, eine Transporteinrichtung der eingangs beschriebenen Gattung anzugeben, bei der die Störung des Beschichtungsvorgangs durch herabrieselndes Schichtmaterial soweit wie irgend möglich unterbleibt.

Die Lösung der gestellten Aufgabe erfolgt bei der eingangs beschriebenen Transporteinrichtung erfindungsgemäß dadurch, daß die Substrathalter (1) ausschließlich im Bereich ihrer Unterkante (2) durch die Rollensysteme (3, 4) geführt sind und daß die Führungsrollen (5, 6) mit Laufflächen (17) versehen sind, die auf mindestens einer Führungsrolle eines Rollenpaares jeweils am unteren und am oberen Ende angeordnet sind, wobei die jeweils andere Führungsrolle des gleichen Rollenpaares mindestens eine Lauffläche (17) aufweist, und daß die mindestens drei Laufflächen (17) eines Rollenpaares in Bezug auf den Substrathalter (1) eine kippsichere Einspannung bilden.

Durch die erfindungsgemäße Lösung sind die Substrathalter auf ihrem Transportweg gewissermaßen fliegend gelagert, und in ihrem oberen Bereich findet keine abrollende oder sich abwälzende Berührung mit irgendwelchen Führungs- und Transportrollen statt. Infolgedessen wird an diesen Stellen auch kein aufgewachsenes Schichtmaterial freigesetzt, wobei zu beachten ist, daß naturgemäß auch die Führungsrollen beschichtet werden und bei ihrer Abwälzbewegung auf den Substrathaltern auch ihrerseits abgeschälte partikel freisetzen würden. Durch den Verzicht auf Führungsrollen im oberen Bereich der Substrathalter tritt eine Verschmutzung der Substrate durch Partikel und die Bildung von « pin holes » nicht mehr im merklichen Umfange ein. Dieser Vorteil ist besonders bedeutsam bei sogenannten Magnetspreicherplatten, bei denen besonders hohe Anforderungen an die Freiheit der Magnetschichten von « pin holes » gestellt werden.

Es genügt dabei eine sogenannte Dreipunkt-Lagerung, d. h. der Substrathalter wird auf einer Seite durch zwei im Abstand voneinander befindliche Laufflächen gestützt und in dieser Position durch eine in der Höhe dazwischenliegende Lauffläche gehalten, die auf der den beiden Laufflächen gegenüberliegenden Seite des Substrathalters auf dessen Oberfläche unter Vorspannung abrollt. Es ist jedoch ganz besonders vorteilhaft, wenn beide Führungsrollen jeweils am unteren und am oberen Ende mit einander gegenüberliegenden Laufflächen versehen sind. Auf diese Weise erfolgt eine außerordentlich stabile Vierpunkt-Abstützung, wie bei dem in den Figuren dargestellten Ausführungsbeispiel.

Es ist schließlich wiederum besonders vorteilhaft, wenn die einzelnen Laufflächen durch elastomere Beläge gebildet werden, die auf den Führungsrollen angeordnet sind.

Es ist dabei weiterhin von Vorteil, wenn der Antrieb für mindestens eine der Führungsrollen unterhalb der Bodenplatte angeordnet ist, die die Vakuumkammer nach unten hin begrenzt.

Auf diese Weise befindet sich der Antrieb, der sowohl ein Motor als auch ein Kettenrad, eine Zahnriemenscheibe etc. sein kann, außerhalb des Vakuumraums und auch außerhalb der Beschichtung. Sämtliche Antriebselemente für die Kettenräder oder Riemenscheiben wie Ketten und Zahnriemen, befinden sich gleichfalls außerhalb der Prozeßräume und werden infolgedessen nicht von Schichtmaterial getroffen.

Vor allem aber kann bei Anbringung des Antriebs außerhalb der Prozeßräume ein über sämtliche Führungsrollen durchgehender Antrieb verwendet werden, was andernfalls nicht möglich wäre, da die einzelnen Behandlungsstationen bzw. Vakuumkammern in der Regel durch Schleusenventile voneinander getrennt werden, die eine Verbindung der Antriebe untereinander innerhalb der Prozeßräume nicht zulassen würden.

Weitere vorteilhafte Ausgestaltungen des Erfindungsgegenstandes sind in den übrigen Unteransprüchen enthalten; sie werden in der Detailbeschreibung näher erläutert.

Ausführungsbeispiele der Erfindungsgegenstandes werden nachfolgend anhand der Figuren 1 bis 5 näher erläutert.

Es zeigen :

Figur 1 eine perspektivische Darstellung eines Substrathalters mit zwei Paaren von führungsrollen einschließlich ihres gemeinsamen Antriebs,

Figur 2 einen teilweisen Vertikalschnitt durch ein Paar von Führungsrollen mit ihrer Lagerung und ihrem Antrieb entlang der Linie II-II in Figur 3,

Figur 3 einen Horizontalschnitt durch den Gegenstand von Figur 2 entlang der Linie III-III,

Figur 4 einen Vertikalschnitt durch eine vollständige Vakuum-Beschichtungsanlage mit einer Transporteinrichtung nach den Figuren 1 bis 3 und

Figur 5 einen vertikalschnitt durch ein Paar von Transportrollen analog zu Figur 2, jedoch mit einem anderen Antriebssystem.

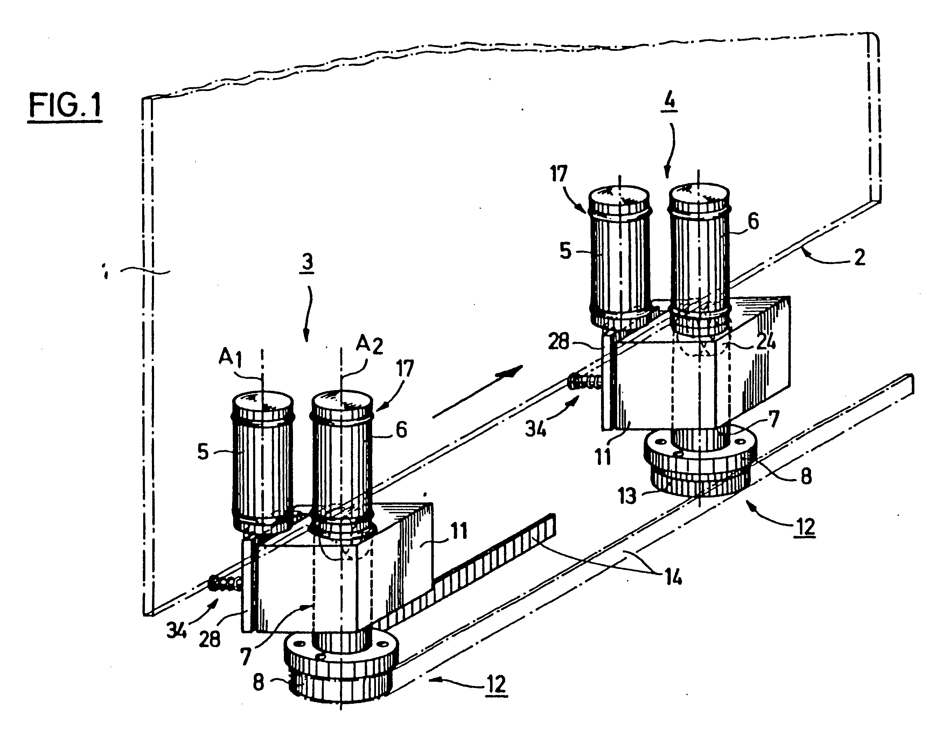

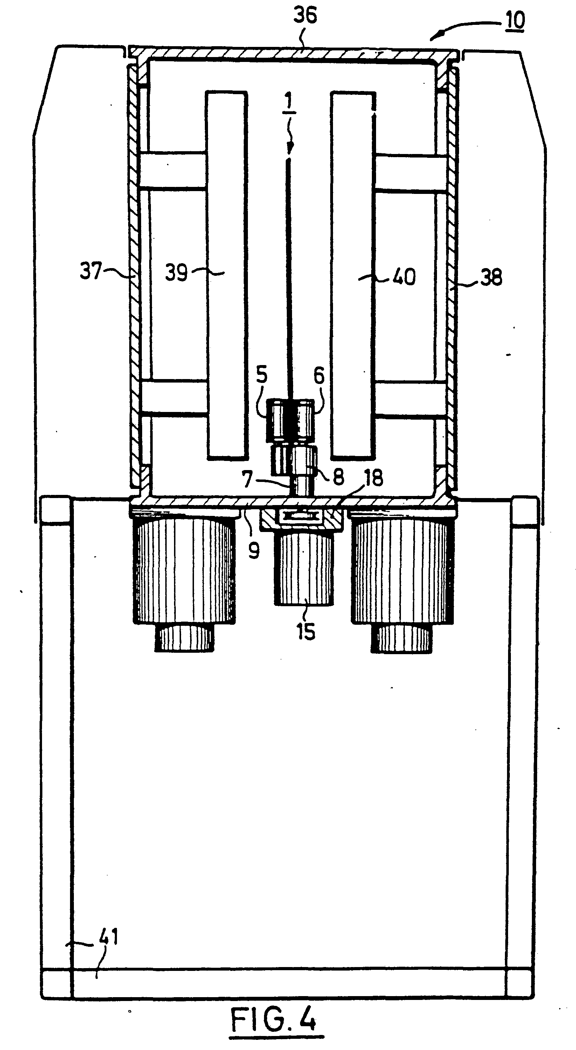

In Fig. 1 ist ein Substrathalter 1 gezeigt, der aus einer senkrecht stehenden, massiven, rechteckigen Platte aus Aluminium mit einer Vielzahl von hier nicht gezeigten Ausnehmungen besteht, die zur Aufnahme einer entsprechenden Anzahl von gleichfalls nicht gezeigten Substraten dienen. Diese Substrate sollen beschichtet werden, während sich der Substrathalter 1 mit gleichförmiger Geschwindigkeit waagrecht relativ zu einer Beschichtungsquelle bewegt (Figur 4). Der Substrathalter besitzt eine Unterkante 2 und ist so dargestellt, als ob er transparent wäre, um die Rollensysteme 3 und 4 besser zeigen zu können.

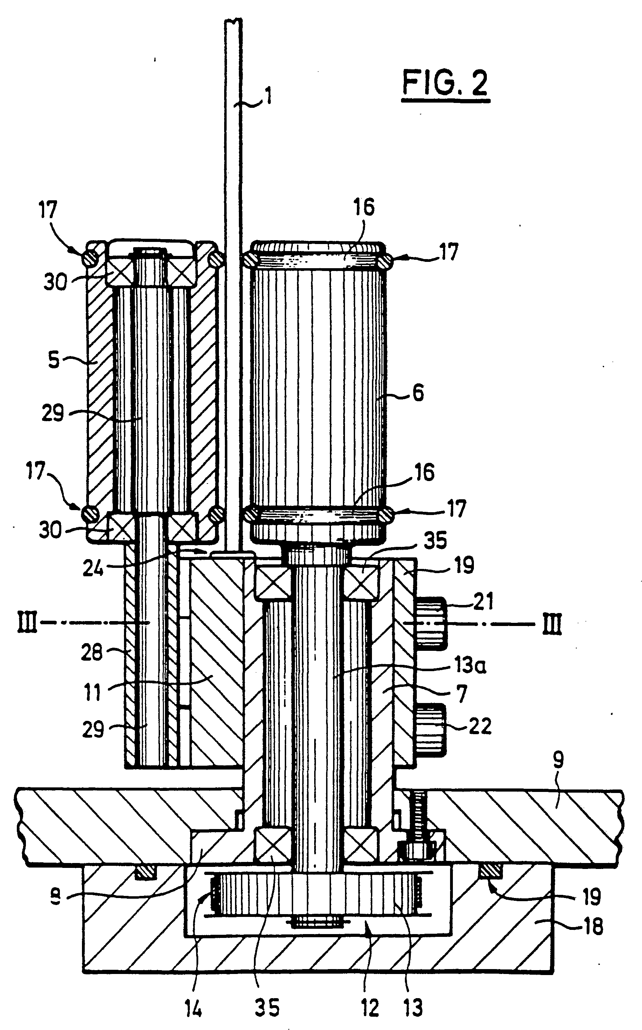

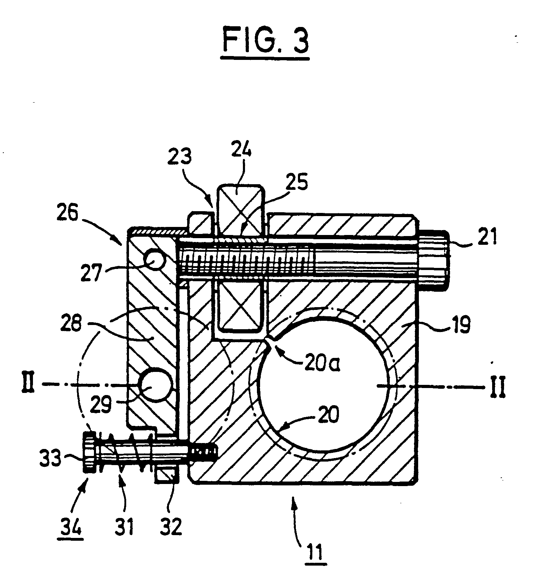

Jedes Rollensystem 3 (oder 4) besteht aus einem Paar von Führungsrollen 5 und 6, die den Substrathalter im Bereich seiner Unterkante 2 zwischen sich einschliessen und kraftschlüssig festhalten. Die Führungsrollen 5 und 6 sind um senkrechte Achsen A1 und A2 drehbar. Die Rollensysteme 3 und 4 sind über jeweils eine Lagerhülse 7 mit einem Flansch 8 an einer hier nicht gezeigten Bodenplatte 9 einer Vakuumkammer 10 befestigt (Figuren 2 und 4). Die Lagerhülse 7 dient zur unmittelbaren Lagerung der Führungsrolle 6. Die andere Führungsrolle 5 ist an der lagerhülse 7 mittels eines lagerbocks 11 befestigt, auf den im Zusammenhang mit den Figuren 2 und 3 noch näher eingegangen werden wird.

An den unteren Enden der die Führungsrollen 6 tragenden Wellen befindet sich je ein Antrieb 12, der aus einer Zahnriemenscheibe 13 mit einem darüber geführten Zahnriemen 14 besteht. Dieser Zahnriemen führt zu einem außerhalb der Zeichenebene liegenden Antriebsmotor 15, so daß die Führungsrollen 6 synchron angetrieben werden.

Wie aus Figur 2 hervorgeht, bestehen die Führungsrollen 5 und 6 aus einem Hohlzylinder, in dessen oberes und unteres Ende je eine Nut 16 eingestochen ist, in die je ein elastomerer Belag 17 eingelegt ist. Dieser elastomere Belag besteht aus einem Rundschnurring mit ausreichender Vakuumfestigkeit. Der rechten Hälfte von Figur 2 ist zu entnehmen, auf welche Weise die Führungsrolle 6 über eine Antriebswelle 13a mit dem Antrieb 12 bzw. mit der Zahnriemenscheibe 13 verbunden ist. Die Zahnriemenscheibe ist mit dem Zahnriemen 14 unterhalb der Bodenplatte 9 angeordnet. Die Abdichtung der Vakuumkammer nach außen hin geschieht durch einen den Zahnriemen 14 auf seiner gesamten Länge übergreifenden Deckel 18, der unter Zwischenschaltung einer Dichtung 19 von unten an die Bodenplatte 9 angesetzt ist.

Während die Führungsrolle 6 mit der Antriebswelle 13a in der Lagerhülse 7 ortsfest gelagert ist, ist die jenseits des Substrathalters 1 befindliche Führungsrolle 5 schwenkbar gelagert, was unter Zuhilfenahme der Figur 3 näher erläutert werden soll :

Der Lagerbock 11 besteht aus einem Klemmstück 19, das eine zylindrische Bohrung 20 und einen hierzu achsparallelen Schlitz 20a aufweist und durch zwei Zugschrauben 21 und 22 auf der Lagerhülse 7 verspannbar ist. Im Klemmstück 19 befindet sich weiterhin eine Ausnehmung 23, in die eine Tragrolle 24 eingesetzt ist, die über die obere Stirnseite des Lagerbocks 11 vorsteht (Figur 2). Die Tragrolle 24 ist auf einer Lagerbuchse 25 gelagert, die ihrerseits wieder von der obersten Zugschraube 21 durchdrungen wird.

An der einen vertikalen Kante des Klemmstücks 19 befindet sich ein Scharnier 26 mit einer Gelenkachse 27, an der ein Tragarm 28 federnd angelenkt ist, in dem eine Bohrung für die Aufnahme eines Lagerzapfens 29 angeordnet ist, der an seinem oberen Ende die Führungsrolle 5 über Kugellager 30 trägt. Der Abstand des Lagerzapfens 29 von der Antriebswelle 13a ist durch die Schwenkbarkeit des Tragarms 28 veränderbar. Der Tragarm 28 steht jedoch unter einer Vorspannung, und zwar unter der Wirkung einer Druckfeder 31, die sich einerseits an einem Fortsatz 32 des Tragarms 28 und andererseits am Kopf 33 einer Stellschraube 34 abstützt. Durch die Einstellung der Stellschraube 34 einerseits und die Wahl der Vorspannung der Druckfeder 31 andererseits läßt sich nicht nur der Abstand der Führungsrollen 5 und 6 voneinander festlegen, sondern auch der Anpreßdruck der Führungsrollen an den Substratalter 1.

Die elastomeren Beläge 17 liegen paarweise jeweils in einer gemeinsamen oberen und untere waagrechten Ebene, so daß innerhalb eines jeden Rollensystems 3 oder 4 jeweils eine Zweipunktabstützung erfolgt, jeder Substrathalter aber an mindestens 4 Punkten gehalten wird.

Aus Figur 2 ist noch ersichtlich, welche räumliche Lage die Tragrolle 24 relativ zu dem Zwischenraum zwischen den Führungsrollen 5 und 6 einnimmt : Es muß dafür Sorge getragen werden, daß der Substrathalter 1 auf der Tragrolle 24 aufliegt und daß die Achse der Tragrolle 24, die mit der Achse der Zugschraube 21 übereinstimmt, in Normalenrichtung zur Hauptebene des Substrathalters 1 verläuft.

Auch die Antriebswelle 13a der Führungsrolle 6 ist mittels Kugellager 35 in der Lagerhülse 7 gelagert.

In Figur 4 ist eine Vakuumkammer 10 gezeigt, die außer der Bodenplatte 9 eine obere Wand 36 und zwei Seitenwände 37 und 38 besitzt. An diesen Seitenwänden ist jeweils eine Beschichtungsquelle 39 und 40 befestigt, die beide als Magnetronkatoden ausgebildet sind, um die in dem Substrathalter 1 befindlichen Substrate von beiden Seiten beschichten zu können. In der Praxis wird man die Beschichtungsquellen 39 und 40 in der Tiefe gestaffelt anordnen. Die Vakuumkammer 10 ist auf einem Traggestell 41 befestigt, damit sich die Seitenwände 37 und 38 im Bereich des Oberkörpers einer Bedienungsperson befinden.

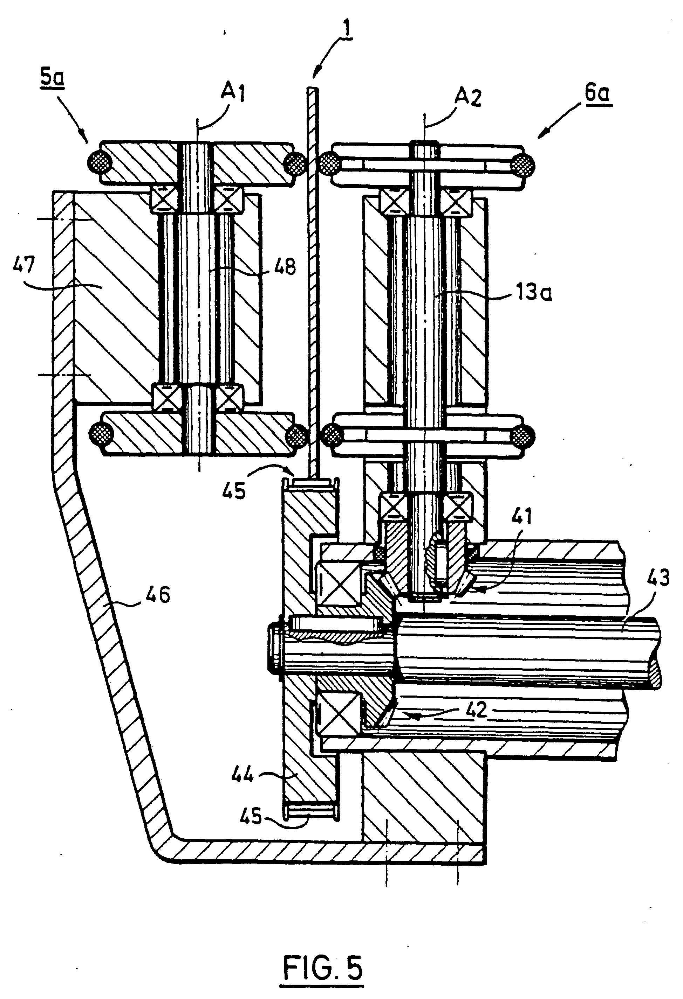

In Figur 5 ist eine Variante des Gegenstandes nach Figur 2 dargestellt : Die Führungsrollen 5a und 6a werden in diesem Falle nicht durch einen durchgehenden Zylinder (aus Metall) gebildet, sondern durch Kreisscheiben, die in axialem Abstand jeweils auf einer gemeinsamen Welle gelagert sind. Die Antriebswelle 13a wird über ein Paar von Kegelrädern 41 und 42 mittels einer waagrechten Welle 43 angetrieben, an deren Ende sich unterhalb des Transportweges des Substrathalters 1 eine Zahnriemenscheibe 44 befindet, die über einen Zahnriemen 45 mit mindestens einer weiteren (nicht dargestellten) Zahnriemenscheibe gekoppelt ist. Es ist erkennbar, daß der Zahnriemen 45 das Tragelement für den Substrathalter 1 ist (analog zu der Tragrolle 24 in den Figuren 1 bis 3).

Die räumliche Festlegung der Führungsrolle 5a gegen- über der Führungsrolle 6a erfolgt durch einen Bügel 46, der an seinem oberen Ende einen Lagerbock 47 für eine nicht angetriebene Welle 48 trägt, auf deren beiden Enden die die Führungsrollen 5a bildenden Kreisscheiben befestigt sind. Durch Verstellung des Bügels 46 läßt sich auch hier der Abstand bzw. die Vorspannung zwischen den beiden Führungsrollen 5a und 6a einstellen.

Bei einem Rollensystem nach Figur 5 ist es — ohne daß alle Details übernommen werden müßten — auch möglich, die Führungsrollen 5a und 6a nicht anzutreiben, d. h. als sogenannte Losrollen zu betreiben, während der Vortrieb ausschließlich durch die Tragrolle 24 (die dann mit einem Antrieb zu versehen ist) bzw. die Zahnriemenscheibe 44 herbeiführbar ist, wobei ein Reibbelag, im Fall von Figur 5 der Zahnriemen 45, für ausreichende Vorschubkräfte sorgt.

**Patentansprüche**

1. Transporteinrichtung für Vakuum-Beschichtungsanlagen mit mehreren Stationen und mit Rollensystemen für die Führung und den Vorschub von im Wesentlichen zweidimensionalen Substrathaltern in senkrechter Stellung entlang eines vorgegebenen Transportweges durch die Stationen, wobei im Bereich der Unterkante der Substrathalter paarweise Führungsrollen angeordnet sind, die den Substrathalter zwischen sich aufnehmen und die um senkrechte Achsen A1, A2, drehbar sind, dadurch gekennzeichnet, daß die Substrathalter (1) ausschließlich im Bereich ihrer Unterkante (2) durch die Rollensysteme (3, 4) geführt sind und daß die Führungsrollen (5, 6) mit Laufflächen (17) versehen sind, die auf mindestens einer Führungsrolle eines Rollenpaares jeweils am unteren und am oberen Ende angeordnet sind, wobei die jeweils andere Führungsrolle des gleichen Rollenpaares mindestens eine Lauffläche (17) aufweist, und daß die mindestens drei Laufflächen (17) eines Rollenpaares in Bezug auf den Substrathalter (1) eine kippsichere Einspannung bilden.

2. Transporteinrichtung nach Anspruch 1, dadurch gekennzeichnet, daß beide Führungsrollen (5, 6) jeweils am unteren und am oberen Ende mit einander gegenüberliegenden Laufflächen versehen sind.

3. Transporteinrichtung nach Anspruch 1, dadurch gekennzeichnet, daß die Laufflächen (17) durch elastomere Beläge gebildet sind, die auf den Führungsrollen (5, 6) angeordnet sind.

4. Transporteinrichtung nach Anspruch 1, dadurch gekennzeichnet, daß die Substrathalter (1) unter Klemmung zwischen den Führungsrollen (5, 6) geführt sind.

5. Transporteinrichtung nach Anspruch 1, dadurch gekennzeichnet, daß mindestens eine Führungsrolle (6) eines Rollenpaares angetrieben ist.

6. Transporteinrichtung nach Anspruch 1, dadurch gekennzeichnet, daß der Antrieb (12) für mindestens eine der Führungsrollen (6) unterhalb einer Bodenplatte (9) angeordnet ist, die die Vakuumkammer (10) nach unten hin begrenzt.

7. Transporteinrichtung nach Anspruch 1, dadurch gekennzeichnet, daß für jedes Paar von Führungsrollen (5, 6) ein Lagerbock (11) vorgesehen ist, der aus einem Klemmstück (19) für eine Lagerhülse (7) der einen Führungsrolle (6) und aus einem federnd angelenkten Tragarm (28) für die Aufnahme eines Lagerzapfens (29) der anderen Führungsrolle (5) besteht, wobei der Abstand des Lagerzapfens (29) vom Klemmstück (19) und der Anpreßdruck durch eine Stellschraube (34) einstellbar sind.

8. Transporteinrichtung nach Anspruch 7, dadurch gekennzeichnet, daß im Lagerbock (11) eine Tragrolle (24) mit horizontaler Achse für die Abstützung des Substrathalters (1) gelagert ist.

9. Transporteinrichtung nach Anspruch 5, dadurch gekennzeichnet, daß der Antrieb der einen Führungsrolle (6a) über eine waagrechte Welle (43) und ein Paar von Kegelrädern (41, 42) erfolgt und daß sich am Ende der Welle (43) unterhalb des Transportweges des Substrathalters (1) eine Zahnriemenscheibe (44) befindet, die über einen Zahnriemen (45) mit mindestens einer weiteren Zahnriemenscheibe gekoppelt ist und daß der Zahnriemen (45) Tragelement für den Substrathalter ist.

## Claims

1. A transporting apparatus for vacuum deposition plant with a plurality of stations and with roller systems for the guidance and advancement of essentially two-dimensional substrate holders in a vertical position along a given transportation path through the stations, guide rollers being arranged in pairs in the region of the lower edge of the substrate holders, which guide rollers receive the substrate holder between them and are rotatable about vertical axes A1, A2, characterised in that the substrate holders (1) are guided exclusively in the region of their lower edge (2) through the roller systems (3, 4) and in that the guide rollers (5, 6) are provided with rolling surfaces (17), which are arranged on at least one guide roller of a roller pair at the lower and upper ends respectively, the respective other guide roller of the same roller pair comprising at least one rolling surface (17), and in that the at least three rolling surfaces (17) of a roller pair form a stable clamping means for the substrate holder (1).

2. A transporting apparatus according to claim 1, characterised in that the two guide rollers (5, 6) are provided at their lower and upper ends respectively with opposing rolling surfaces.

3. A transporting apparatus according to claim 1, characterised in that the rolling surfaces (17) are formed by elastomer coatings disposed on the guide rollers (5, 6).

4. A transporting apparatus according to claim 1, characterised in that the substrate holders (1) are guided so that they are clamped between the guide rollers (5, 6).

5. A transporting apparatus according to claim 1, characterised in that at least one guide roller (6) of a roller pair is driven.

6. A transporting apparatus according to claim 1, characterised in that the drive (12) for at least one of the guide rollers (6) is arranged beneath a base plate (9) which forms the bottom of the vacuum chamber (10).

7. A transporting apparatus according to claim 1, characterised in that for each pair of guide rollers (5, 6) a bearing block (11) is provided, which is formed by a clamping element (19) for a bearing sleeve (7) of the first guide roller (6) and a resiliently mounted supporting arm (28) for receiving a journal (29) of the second guide roller (5), the distance between the journal (29) and the clamping element (19) and the contact pressure being adjustable by means of an adjusting screw (34).

8. A transporting apparatus according to claim 7, characterised in that a supporting roller (24) having a horizontal axis for supporting the substrate holder (1) is mounted in the bearing block (11).

9. A transporting apparatus according to claim 5, characterised in that the drive of the first guide roller (6a) is effected via a horizontal shaft (43) and a pair of bevel gears (41, 42) and in that a toothed belt disc (44) is arranged at the end of the shaft (43) beneath the transportation path of the substrate holder (1), which toothed belt disc (44) is coupled via a toothed belt (45) with at least one further toothed belt disc and in that the toothed belt (45) acts as a supporting element for the substrate holder.

## Revendications

1. Dispositif de transport pour installations de revêtement sous vide avec plusieurs postes et avec des systèmes de galets pour le guidage et l'avance de porte-substrats sensiblement bidimensionnels, disposés verticalement, le long d'un trajet de transport prédéterminé passant par les postes, des galets de guidage étant agencés par paires, dans la région du bord inférieur des porte-substrats qu'ils reçoivent entre eux, et pouvant tourner autour d'axes verticaux A1, A2, caractérisé par le fait que les porte-substrats (1) sont guidés exclusivement dans la région de leur bord inférieur (2), par les systèmes de galets (3, 4), et par le fait que les galets de guidage (5, 6) sont munis de surfaces de roulement (17) qui, sur au moins un galet de guidage appartenant à une paire de galets, sont agencées à chaque fois à l'extrémité inférieure et à l'extrémité supérieure, l'autre galet de guidage de la même paire de galets présentant au moins une surface de roulement (17), et par le fait que les surfaces de roulement (17) au nombre d'au moins trois d'une paire de galets forment, par rapport au porte-substrats (1), une emprise empêchant le basculement.

2. Dispositif de transport selon revendication 1, caractérisé par le fait que les deux galets de guidage (5, 6) sont munis de surfaces de roulement situées en vis-à-vis, disposées à leur extrémité inférieure et à leur extrémité supérieure.

3. Dispositif de transport selon revendication 1, caractérisé par le fait que les surfaces de roulement (17) sont constituées par des garnitures en élastomère agencées sur les galets de guidage (5, 6).

4. Dispositif de transport selon revendication 1, caractérisé par le fait que les porte-substrats (1) sont guidés en étant serrés entre les galets de guidage (5, 6).

5. Dispositif de transport selon revendication 1, caractérisé par le fait qu'au moins un galet de guidage (6) d'une paire de galets est entraîné.

6. Dispositif de transport selon revendication 1, caractérisé par le fait que l'entraînement (12) pour au moins l'un des galets de guidage (6) est agencé en dessous d'une plaque de fond (9) qui limite vers le bas la chambre à vide (10).

7. Dispositif de transport selon revendication 1, caractérisé par le fait qu'il est prévu, pour chaque paire de galets de guidage (5, 6), un support (11) qui est constitué par une pièce de serrage (19) pour une douille de palier (7) du pemier galet de guidage (6) et par un bras-support (28), élastiquement rapporté par une articulation, destiné à recevoir un tourillon (29) de l'autre galet de guidage (5), la distance du tourillon (29) à la pièce de serrage (19) et la pression d'appui étant réglables par une vis de réglage (34).

8. Dispositif de transport selon revendication 7, caractérisé par le fait qu'un galet-support (24) avec axe horizontal est monté dans le support (11), pour supporter le porte-substrats (1).

9. Dispositif de transport selon revendication 5, caractérisé par le fait que l'entraînement du premier galet de guidage (6a) s'effectue par un arbre horizontal (43) et par une paire de roues coniques (41, 42), et par le fait qu'il y a, à l'extrémité de l'arbre (43), en dessous du trajet de transport du porte-substrats (1), une poulie (44) à courroie dentée, qui, par une courroie dentée (45), est accouplée à au moins une autre poulie à courroie dentée (45), est accouplée à au moins une autre poulie à courroie dentée, et par le fait que la courroie dentée (45) est un élément-support pour supporter le porte-substrats.

FIG.1

FIG. 2

EP 0 254 145 B1

# FIG. 3

FIG.4

## FIG. 5